# EUROPEAN PATENT APPLICATION

(11) **EP 3 419 058 A2**
(43) Date of publication of application: **26.12.2018**
(21) Application number: 18178866.2
(22) Date of filing: 20.06.2018
(51) Int. Cl.: H01L 31/0392, H01L 31/05, H02S 40/36, H01L 31/048

(54) **REEL-TYPE PACKAGED FLEXIBLE ASSEMBLY MODULE AND REEL-TYPE FLEXIBLE PHOTOVOLTAIC POWER STRIP**

(30) Priority: 20.06.2017 CN 201720717186 U; 14.06.2018 WO PCT/CN2018/091259
(71) Applicant: Beijing Apollo Ding Rong Solar Technology Co., Ltd., Beijing 100176 (CN)
(72) Inventor: WANG, Yunfang, Beijing, Beijing 100176 (CN); DAI, Fengyu, Beijing, Beijing 100176 (CN); HUO, Yanyin, Beijing, Beijing 100176 (CN); CAO, Zhifeng, Beijing, Beijing 100176 (CN)
(74) Representative: D'Halleweyn, Nele Veerle Trees Gertrudis

(57) **Abstract**

A reel-type packaged flexible assembly module is provided. The reel-type packaged flexible assembly module includes a packaging cloth, cables and two or more flexible photovoltaic assemblies. The two or more flexible photovoltaic assemblies are bonded to one packaging cloth. The two or more flexible photovoltaic assemblies are connected in series through cables.

## Description

### Technical Field

The present application relates to, but is not limited to, the solar power field, and particularly relates to a reel-type packaged flexible assembly module and a reel-type flexible photovoltaic power strip.

### Background

Today's society relies mainly on traditional fossil energy sources. And 74 % of the total global energy consumption comes from coal, oil, natural gas and other mineral sources. The application of fossil energy has promoted the development of society, but the resources are increasingly exhausted. The uncontrolled use of fossil energy has caused serious environmental pollution and climate change problems. Countries all over the world deem the development of renewable energy and the new energy as an important component of their future energy strategy, and solar energy is one important development target thereof.

As a result of the rapid development of solar cells, especially flexible solar cells such as thin films, there is a prospect that these problems can be solved. At present, corresponding products have emerged in the market, such as solar charging paper, solar charging bag, etc. However, such charging equipment can only meet the short-term emergency use. The solar power generation is unstable and thus cannot meet the power supply requirement needed by large or medium-sized appliances.

With the emergence of flexible solar panels, many portable solar charging devices have been invented, but these portable solar charging devices still have many flaws, such as the area of available solar panels is too small, or the solar charging devices are not easy to carry. For example, a common solar battery pack structure includes two substrates which are hinged with each other. The solar cell is set on the substrate, the solar cell is also provided with the upper over. This solar battery pack can be folded around. However, the solar battery pack substrate is made of hard material and can only be folded simply. After being folded, the area thereof is still very large. Moreover, the thickness of the solar battery pack is also very thick, which makes the battery pack inconvenient to carry. The power of cell assemblies that can be held in the solar battery pack is not high enough.

### Summary

The following is an overview of the subject matter described in detail herein. This summary is not intended to limit the protection scope of the claims.

The application provides a reel-type packaged flexible assembly module and a reel-type flexible photovoltaic power strip, both of which are applied to high-power and large-area electricity generation, and the assembly and electrical connection thereof are easy.

An embodiment of this application discloses reel-type packaged flexible assembly module which includes a packaging cloth, cables and flexible photovoltaic assemblies. Two or more flexible photovoltaic assemblies are bonded to one packaging cloth. The flexible photovoltaic assemblies are connected in series through the cables.

In an exemplary embodiment, a thin tubular storage hidden bag is provided on a surface of the packaging cloth for holding cables. The thin tubular storage hidden bag has an H-shaped overall layout. The middle horizontal line portion of the thin tubular storage hidden bag is used for series connection of the horizontally arranged assemblies and the longitudinal portions on both sides of the thin tubular storage hidden bag are used the arrangement of the bus cables. Four ends of the reel-type packaged flexible assembly module are provided with a T-shape bus device, and there is a connection interface which is reserved for a in parallel connection between two reel-type packaged flexible assembly modules or an electrical connection between the reel-type packaged flexible assembly module and reel internal electrical appliances.

In an exemplary embodiment, the T-shape bus device includes connection cables and connectors, having three identical plug-in terminals, achieving a three-way connection. The connectors are waterproof and sealed.

In an exemplary embodiment, bonding the flexible photovoltaic assemblies to the packaging cloth is achieved by EVA/POE/PVB film material. Edges of a wear-resistant -interlining cloth are folded to enclose four edges of the assembly with a sealant. The packaging cloth is the wear-resistant interlining cloth.

In an exemplary embodiment, a plurality of holes and fasteners are arranged at both ends of the packaging cloth in the reel-type packaged flexible assembly module for fixing and hanging and for mechanically connecting a plurality of packaging cloth. Both ends of the packaging cloth are provided with an elongated rod-shaped hard material which has a length equal to a width of the packaging cloth. The elongated rod-shaped hard material is horizontally across the packaging cloth for supporting the packaging cloth, and preventing the packaging cloth from deforming when in use.

In an exemplary embodiment, a reel-type flexible photovoltaic power strip is provided, which is formed by parallel connecting one or two reel-type packaged flexible assembly modules described above.

In an exemplary embodiment, a plurality of reel-type packaged flexible assembly modules are connected in parallel to form a standard string. One group of bus cables is used. A number of bus cables is the same as that of the standard strings.

In an exemplary embodiment, a diameter of the roller is not greater than 550mm.

An embodiment of this application further provides a reel-type packaged flexible assembly module which includes a packaging cloth, cables and two or more flexible photovoltaic assemblies. The two or more flexible photovoltaic assemblies are bonded to the packaging cloth. The cables are electrically connected with the flexible photovoltaic assemblies.

In an exemplary embodiment, the two or more flexible photovoltaic assemblies are bonded to one packaging cloth and connected in series by the cables.

In an exemplary embodiment, bonding the flexible photovoltaic assembly to the packaging cloth is achieved by EVA (Ethylene-vinyl acetate copolymer), POE plastic or PVB (Polyvinyl butyral).

In an exemplary embodiment, the edges of the packaging cloth are folded to enclose four edges of the flexible photovoltaic assembly. The four edges of the flexible photovoltaic assembly are enclosed by a sealant.

In an exemplary embodiment, the packaging cloth is wear-resistant interlining cloth.

In an exemplary embodiment, one or more of a hole, a fastener and a hard material are arranged at both ends of the packaging cloth.

In an exemplary embodiment, a plurality of the holes are provided and configured to connect with adjacent reel-type packaged flexible assembly modules. The fastener is configured to bond two reel-type packaged flexible assembly modules together. The hard material has a length which is equal to a width of the packaging cloth, and the hard material is elongated rod-shaped, arranged on both ends of the packaging cloth. The hard material extends horizontally across the packaging cloth.

In an exemplary embodiment, the two or more flexible photovoltaic assemblies are horizontally arranged on the packaging cloth. The cables include cables connected in series between the flexible photovoltaic assemblies horizontally arranged and bus cables used for parallel connecting a plurality of the reel-type packaged flexible assembly module.

In an exemplary embodiment, a thin tubular storage hidden bag is provided on a surface of the packaging cloth for holding the cables.

In an exemplary embodiment, the thin tubular storage hidden bag has an H-shaped overall layout. A middle horizontal portion of the thin tubular storage hidden bag is configured to hold the cables connected in series between the flexible photovoltaic assemblies horizontally arranged, and longitudinal portions on both sides of the thin tubular storage hidden bag are used to arrange the bus cables.

In an exemplary embodiment, two or four ends of the reel-type packaged flexible assembly module are provided with a T-shape bus device which includes a connector configured to enable a parallel electrical connection between two said reel-type packaged flexible assembly modules or enable an electrical connection between the reel-type packaged flexible assembly module and an electrical appliance.

In an exemplary embodiment, the T-shape bus device includes three connectors and connection cables connected between the three connectors. The three connectors have three identical plug-in terminals, forming a three-way electrical connection.

An embodiment of this application further provides a reel-type flexible photovoltaic power strip including the reel-type packaged flexible assembly modules according to any embodiment described above. The reel-type packaged flexible assembly modules are electrically connected in parallel.

In an exemplary embodiment, the plurality of the reel-type packaged flexible assembly modules are connected in parallel by a group of bus cables to form a standard string. Each group of bus cables is configured to connect with a maximum power point tracking device.

An embodiment of the application provides a reel-type packaged flexible assembly module. By mechanical connection and electrical connection, the assembly can form a reel-type flexible photovoltaic power strip, which is mainly applied to a reel-type flexible photovoltaic power strip component on a roller and can be extended indefinitely in theory and winded to save space. The reel-type packaged flexible assembly module has a simple structure and is easy to be wound, and can be assembled into a reel-type flexible photovoltaic power strip, and the number of assemblies which assembled can be chosen as needed.

Other aspects will become apparent after reading and understanding the drawings and detailed description.

### Brief Description of Drawings

Fig. 1 is a schematic view of the structure of a reel-type packaged flexible assembly module according to an embodiment of the present application.
Fig. 1a is a schematic cross-sectional top view of the structure of the reel-type packaged flexible assembly module shown in Fig. 1, but the line along which this cross-sectional view is taken is not shown.
Fig. 1b is a schematic cross-sectional left view of the structure of the reel-type packaged flexible assembly module shown in Fig. 1, but the line along which this cross-sectional view is taken is not shown.
Fig. 2 is a schematic view of the structure of two reel-type packaged flexible assembly modules connected to each other according to an embodiment of the present application.
Fig. 3 is a schematic enlarged view of the structure of the part A in Fig. 2.
Fig. 4 is a schematic view of the structure of a cable and a T-shape bus device of the reel-type packaged flexible assembly module according to an embodiment of the present application.
Fig. 5 is a schematic view of the structure of a T-shape bus device connected with a cable according to an embodiment of the present application.
Fig. 6 is a schematic view of the structure of a photovoltaic power trailer-type compartment according to an embodiment of the present application.
Fig. 7 is a schematic view of the structure of a circuit of the photovoltaic power trailer-type compartment according to an embodiment of the present application.

### Detailed Description

The disclosure is further explained by way of example with reference to the figures.

One embodiment relates to a reel-type packaged flexible assembly module which consists of a plurality of photovoltaic assemblies bonded to a wear-resistant interlining cloth. The edges of the wear-resistant interlining cloth are folded to enclose the photovoltaic assemblies. The four edges of the assembly are wrapped by sealant. The number of photovoltaic assemblies is 2 to 12, and in an example, the number is 6.

One embodiment relates to a reel-type flexible photovoltaic power strip 4 which consists of a plurality of reel-type packaged flexible assembly modules 8. The reel-type packaged flexible assembly module consists of a packaging cloth 9, cables and flexible photovoltaic assemblies 10. The number of assembly modules is 2 to 10, and in an example, the number is 6.

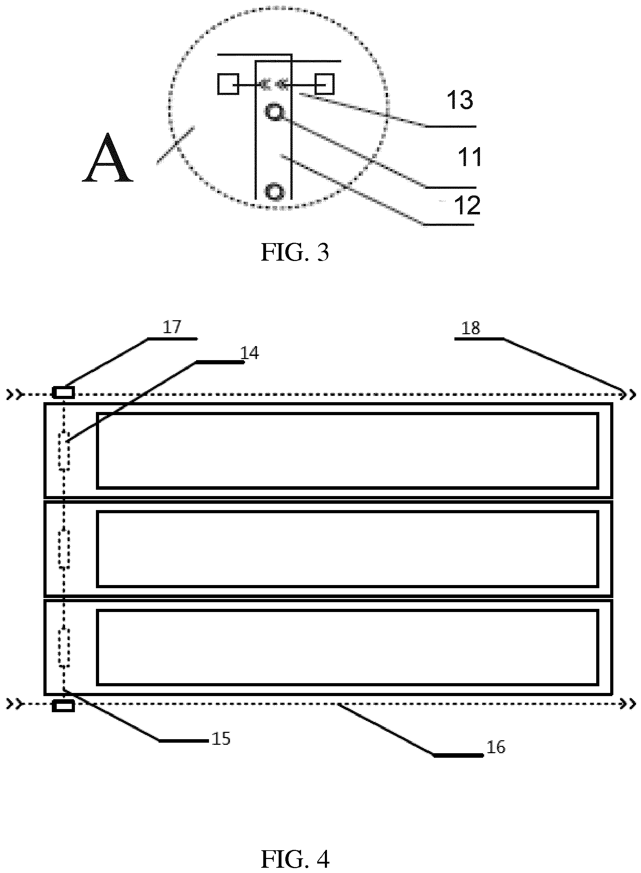

A thin tubular storage hidden bag is provided on the surface of the packaging cloth for holding cables. The thin tubular storage hidden bag has an H-shaped overall layout. The middle horizontal portion of the thin tubular storage hidden bag enables the series connection of the horizontally-arranged assemblies. As shown in Fig. 4, three horizontally-arranged assemblies connect the cable boxes 14 of the assemblies in series by the horizontal series-connecting cables 15. The longitudinal portions on both sides of the thin tubular storage hidden bag are used to arrange the bus cables 16. Four ends of the reel-type packaged flexible assembly module are provided with a T-shape bus device 17, and there is a connection interface 18 which is reserved to enable the parallel connection between two reel-type packaged flexible assembly modules or the electrical connection between the reel-type packaged flexible assembly module and electrical appliances within a roller. Arranging the cables along the edges can reduce the thickness of the reel-type packaged flexible assembly module 8 and increase the longitudinal mechanical strength of the same.

A thin tubular storage hidden bag is provided on the edges of the surface of the packaging cloth for arranging and connecting the cables. The thin tubular storage hidden bag is arranged between the back of the flexible photovoltaic assembly and the packaging cloth.

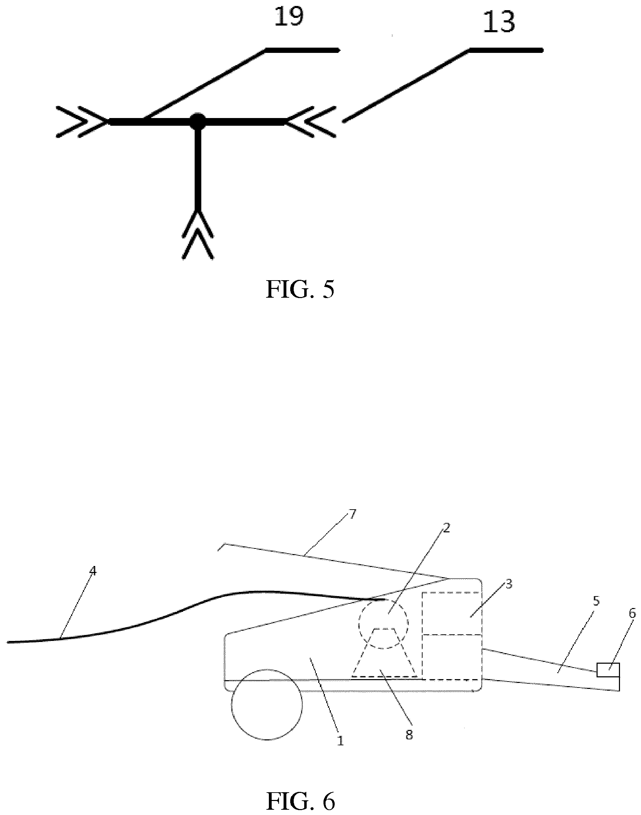

As shown in Fig. 5, the T-shape bus device 17 consists of connection cables 19 and connectors 13, having three identical plug-in terminals, achieving a three-way connection. The connectors are waterproof and sealed.

The reel-type packaged flexible assembly modules are modularized, and are connected end to end. In this way, parallel connection bus can be realized and thus capacity increase can be achieved.

A plurality of reel-type packaged flexible assembly modules are connected in parallel to form a standard string. One group of bus cables is used. The number of bus cables is the same as that of the standard strings. Each group of bus cables is connected with a maximum power point tracking (MPPT) device, and each group of bus cables includes two cables, one of which is a positive cable and the other is a negative cable. Each standard string is associated with one MPPT device. Such a design guarantees that the standard string is able to generate electricity independently, even when part of the assemblies are damaged, shaded or cannot be pulled out, and the functional standard string still can generate electricity at maximum efficiency.

A photovoltaic power trailer-type compartment includes an expandable trailer-type compartment 1, a reel-type packaged flexible photovoltaic power device 2, and a power generation circuit 3.

The reel-type packaged flexible photovoltaic power device 2 is arranged in the expandable trailer-type compartment 1, and includes a winding mechanism and a reel-type flexible photovoltaic power strip 4 which is wound on the winding mechanism.

The power generation circuit is electrically connected to the reel-type flexible photovoltaic strip.

The panel is arranged at the center of the side surface of the roller. The panel is provided with input and output ports and is electrically connected with the panel circuit.

The trailer-type compartment body is the trailer-type compartment 1 which is connected to a vehicle by a hook 5, for moving the trailer-type compartment by pulling the same.

A power interface circuit 6 is arranged at the hook and is configured to supply energy from the trailer-type compartment to the vehicle.

The vertical wall of the trailer-type compartment consists of openable side plates which can be horizontally deployed and fixed.

The ceiling of the trailer-type compartment 1 consists of an openable top plate 7 which can be opened and the angle of the top plate can be adjusted. After the top plate is opened, it is possible to operate the equipment in the trailer-type compartment.

In the front surface of the trailer-type compartment, a function panel is provided, which includes a data display screen, a switch, and an energy interface.

The winding mechanism includes a roller, a rocker arm and a power assisted motor 8.

The roller is configured to winding and accommodating the reel-type packaged assembly. Both ends of the roller are provided with flanges which are configured to confine the position of the assembly. The rocker arm is a retractable rocker arm which is arranged to rotate the roller. The power assisted motor is arranged to be connected to the roller and used for rotating the roller with electricity. The diameter of the roller is 500mm.

Further, a plurality of holes 11 and fasteners 12 are arranged at both ends of the packaging cloth in each reel-type packaged flexible assembly module. The holes 11 and fasteners 12 are arranged to mechanically connect the packaging cloth. Both ends of the packaging cloth are provided with an elongated rod-shaped hard material. The length of the hard material is the same as the width of the packaging cloth. The hard material is horizontally across the packaging cloth and is arranged to support the packaging cloth, preventing the packaging cloth from deforming when in use, and improving the horizontal mechanical strength of the reel-type packaged flexible assembly module.

The assemblies are plug-connected to the power generation circuit in parallel by the connectors 13. Two assemblies are connected by buckled lap-connecting the holes 11 and bonded connection by the hook-and-loop fastener (Velcro) 12.

The trailer-type compartment further includes a bonded-type flexible photovoltaic assembly device which can be directly attached to the top and the side faces of the trailer-type compartment to form three standard strings. The bonded-type flexible photovoltaic assembly device is a flexible photovoltaic assembly having ETFE flexible packaging. The pasting-type flexible photovoltaic assembly device is directly attached to the openable top plate and side plates of the trailer-type compartment. Cable grooves with cover are provided.

A power generation circuit is provided in the roller. An electrical system is provided in the winding mechanism. The electrical system includes a maximum power point tracking device, a DC power supply, a charging circuit, an AC power supply, a battery and a panel circuit. Each group of bus cables is connected with one maximum power point tracking device, and then is connected with the battery and/or the AC power supply after passing through the DC power supply, and is finally connected with the panel circuit. An inverter is connected between the DC power supply and the AC power supply.

The power of each maximum power point tracking (MPPT) device may be 1200W.

The DC power supply converts fluctuating photovoltaic power into a stable DC power and is configured for charging batteries, driving external DC electrical appliances and supplying power to the inverter. The DC power supply can output direct currents of various voltage levels such as 5V, 12V, 24V. The power of the DC power supply can be 1000 W.

The AC power supply (provided with an inverter) is used to convert a direct current from the DC power supply or the battery into an alternating current of 110 V or 220 V by the inverter, to supply power to external AC electrical appliances, the power can be 1200 W.

The battery which may be a lithium battery is used for storing energy, and the energy stored in the battery can be 2000Wh.

The charging circuit charges the battery by using the alternating current which is supplied from outside when there is no sunlight in the environment or solar power is not used for generating electricity.

The panel circuit includes a protection circuit which protects the output power supply from shorting by using a fuse and a panel which consists of an AC socket, a DC socket, a USB socket and a charging interface.

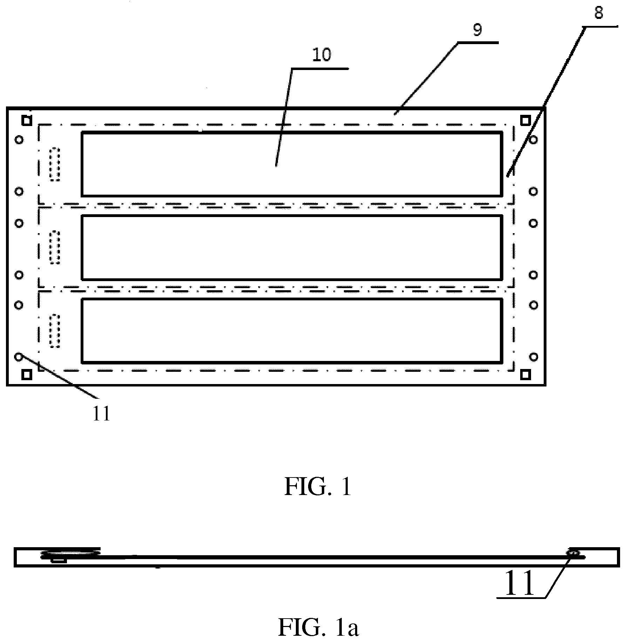

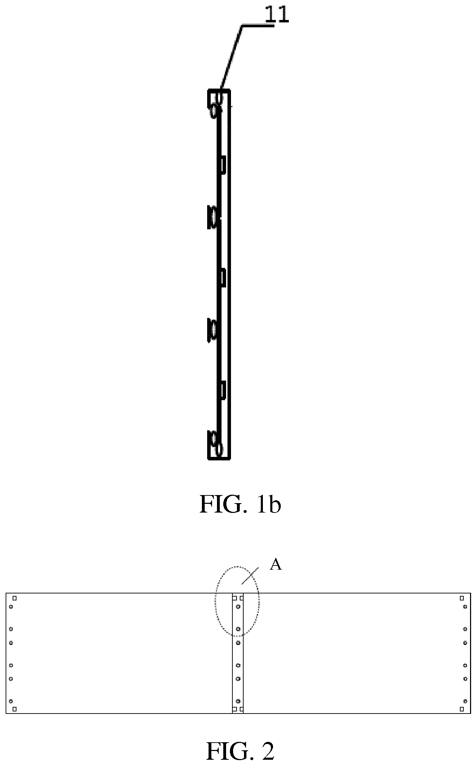

As shown in Fig. 1, an embodiment of this application provides a reel-type packaged flexible assembly module which includes flexible photovoltaic assemblies and a packaging cloth. A plurality of flexible photovoltaic assemblies are bonded to the packaging cloth. The edges of the packaging cloth are folded to enclose the flexible photovoltaic assemblies (as shown in Figs.1, 1a and lb). The four edges of the assembly are wrapped by sealant. The number of flexible photovoltaic assemblies is 2 to 12, and can be set to 6. The plurality of flexible photovoltaic assemblies are connected to each other by cables.

As shown in Figs. 2 and 3, an embodiment of this application provides a reel-type flexible photovoltaic power strip 4 which includes a plurality of reel-type packaged flexible assembly modules 8. With reference to Fig. 1, the reel-type packaged flexible assembly module includes a packaging cloth 9, cables and flexible photovoltaic assemblies 10. The number of the flexible photovoltaic assemblies is 2 to 10, in an example, the number is 6.

A thin tubular storage hidden bag is provided on the surface of the packaging cloth 9 for holding cables. The cables include series-connecting cables 15 and a bus cable 16. The bus cable 16 is arranged along the edge of the packaging cloth. The thin tubular storage hidden bag has an H-shaped overall layout, as shown in Fig. 1. The middle horizontal portion of the thin tubular storage hidden bag is configured to hold the series-connecting cables 15 positioned between the horizontally-arranged flexible photovoltaic assemblies. As shown in Figs. 1 and 4, three horizontally-arranged flexible photovoltaic assemblies 10 connect the cable boxes 14 of the three flexible photovoltaic assemblies 10 in series by the horizontal series-connecting cables 15. The longitudinal portions on both sides of the thin tubular storage hidden bag are used to arrange the bus cables 16. Two ends (as shown in Fig. 4) or four ends of the reel-type packaged flexible assembly module are provided with a T-shape bus device 17, and there is a connection interface 18 which is reserved to enable the parallel connection between two reel-type packaged flexible assembly modules. Arranging the cables along the edges can reduce the thickness of the reel-type packaged flexible assembly module 8 and increase the longitudinal mechanical strength of the same.

A thin tubular storage hidden bag is provided on the edges of the surface of the packaging cloth for holding cables. The thin tubular storage hidden bag can be configured for arranging and connecting the cables and is arranged between the back of the flexible photovoltaic assembly and the packaging cloth.

As shown in Figs. 4 and 5, the T-shape bus device 17 includes a connection cable 19 and three connectors 13. The three connectors 13 form three identical plug-in terminals, achieving a three-way connection. The connectors 13 are waterproof and sealed.

The connection cable is a T-shape cable, and the interface formed by the plug-in terminals is the connection interface 18.

The three connectors 13 are connected to the three ends of the connection cable 19, and one end of the horizontal series-connecting cable 15 of the cables is electrically connected to the bus cable 16 through two connectors 13 of the T-shape bus device 17. The other connector 13 of the T-shape bus device 17 can be connected when two reel-type packaged flexible assembly modules 8 are connected in parallel.

The reel-type packaged flexible assembly module is modularized. Adjacent reel-type packaged flexible assembly modules are connected end to end by the reserved connectors 13. By using the bus cable, parallel bus can be realized and thus capacity can be increased.

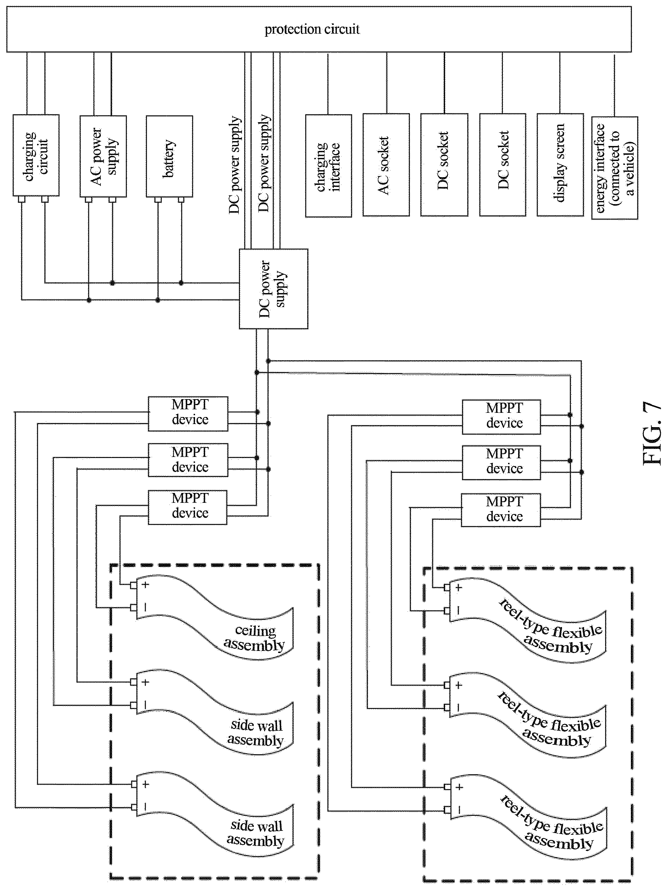

A plurality of reel-type packaged flexible assembly modules are connected in parallel by a group of bus cables to form a standard string. The number of bus cables is the same as that of the standard strings. Each group of bus cables is connected with a maximum power point tracking (MPPT) device, and each group of bus cables includes two cables, one of which is a positive cable and the other is a negative cable. Each standard string is associated with one MPPT device (as shown in Fig. 7). Such a design guarantees that the standard string is able to generate electricity independently, even when part of the assemblies are damaged, shaded or cannot be pulled out, and the functional standard string still can generate electricity at maximum efficiency.

As shown in Fig. 6, an embodiment of the present application also provides a photovoltaic power trailer-type compartment, which includes an expandable trailer-type compartment 1, a reel-type packaged flexible photovoltaic power device 2, and an electrical system 3.

The reel-type packaged flexible photovoltaic power device 2 is arranged in the expandable trailer-type compartment 1, and includes a winding mechanism and a reel-type flexible photovoltaic power strip 4 which is arranged to be wound on the winding mechanism.

The winding mechanism includes a roller in which an electrical system 3 is arranged. A panel is arranged on the side surface of the roller.

The electrical system 3 is electrically connected to the reel-type flexible photovoltaic strip 4.

The panel is arranged at the center of the side surface of the roller and provided with input and output ports. The roller is electrically connected with the panel circuit.

The trailer-type compartment 1 is connected to a vehicle by a hook 5, for moving the trailer-type compartment 1 by pulling the same.

A power interface circuit 6 is arranged at the hook 5 and is configured to supply energy from the trailer-type compartment 1 to the vehicle.

The vertical wall of the trailer-type compartment 1 consists of openable side plates which can be horizontally deployed and fixed.

The ceiling of the trailer-type compartment 1 consists of an openable top plate 7 which can be opened and the angle of the top plate can be adjusted. After the top plate is opened, it is possible to operate the equipment in the trailer-type compartment 1.

In the front surface of the trailer-type compartment 1, a function panel is provided, which includes a data display screen, a switch, and an energy interface.

The energy interface for supplying power to the vehicle is located in the power interface circuit 6, and the function panel is located at the hook 5.

In addition to the roller, the winding mechanism further includes a rocker arm and a power assisted motor 8.

The roller is configured to wind and hold the reel-type flexible photovoltaic power strip 4. The two ends of the roller are provided with flanges which are configured to confine the position of the reel-type flexible photovoltaic power strip 4. The rocker arm is a retractable rocker arm which is arranged to rotate the roller. The power assisted motor 8 is arranged to be connected to the roller and used for rotating the roller with electricity. The diameter of the roller is 500mm.

The diameter of the roller can be set to not greater than 550 mm. Further, a plurality of holes 11 and fasteners 12 are arranged at both ends of the packaging cloth in each reel-type packaged flexible assembly module. The holes 11 and fasteners 12 are arranged to mechanically connect the reel-type flexible photovoltaic power strip 4 and the adjacent packaging cloth. Both ends of the packaging cloth are provided with an elongated rod-shaped hard material. The length of the hard material is the same as the width of the packaging cloth. The hard material is horizontally across the packaging cloth and is arranged to support the packaging cloth, preventing the packaging cloth from deforming when in use, and improving the horizontal mechanical strength of the reel-type flexible photovoltaic power strip 4.

The plurality of holes 11 are arranged to be connected with the adjacent reel-type packaged flexible assembly modules. The fasteners 12 are arranged to bonded connecting two reel-type packaged flexible assembly modules. The length of the hard material is the same as the width of the packaging cloth. The hard material takes the shape of an elongated rod. The hard materials are arranged at both ends of the packaging cloth and extend across the packaging cloth horizontally.

Referring to Figs. 4 and 5, adjacent reel-type packaged flexible assembly modules are plug-connected to the power generation circuit in parallel by the connectors 13. Two adjacent reel-type packaged flexible assembly modules are connected by lap-connecting the holes 11 and bonded connecting the fastener 12.

The photovoltaic power trailer-type compartment further includes a bonded-type flexible photovoltaic assembly device which can be directly adhered to the top and the side faces of the trailer-type compartment 1 to form three standard strings. The bonded-type flexible photovoltaic assembly device is a flexible photovoltaic assembly having ETFE flexible packaging. The bonded-type flexible photovoltaic assembly device is directly attached to the openable top plate and side plates of the trailer-type compartment 1. Cable grooves with cover are provided on the top plate and side plates.

The bonded-type flexible photovoltaic assembly device is connected with a DC power supply through three maximum power point tracking devices. ETFE is Ethylene-tetrafluoroethylene copolymer. The side face is located on the side plate.

An electrical system is provided in the winding mechanism. As shown in Fig. 7, the electrical system includes a maximum power point tracking device, a DC power supply, a charging circuit, an AC power supply, a battery and a panel circuit. Each group of bus cables is connected with one maximum power point tracking device, and then is connected with any one or two of the battery and the AC power supply after passing through the DC power supply, and is finally connected with the panel circuit. An inverter is connected between the DC power supply and the AC power supply.

The power of each maximum power point tracking (MPPT) device may be 1200W.

The DC power supply converts fluctuating photovoltaic power into a stable DC power and is configured for charging batteries, driving external DC electrical appliances and supplying power to the inverter. The DC power supply can output direct currents of various voltage levels such as 5V, 12V, 24V. The power of the DC power supply can be 1000 W.

The AC power supply (provided with an inverter) is used to convert a direct current from the DC power supply or the battery into an alternating current of 110 V or 220 V by the inverter, to supply power to external AC electrical appliances. The power of the AC power supply can be 1200 W.

The battery which may be a lithium battery is used for storing energy, and the energy stored in the battery can be 2000Wh.

The charging circuit charges the battery by using the alternating current which is supplied from outside when there is no sunlight in the environment or solar power is not used for generating electricity.

The panel circuit includes a protection circuit which protects the output power supply from shorting by using a fuse. The panel consists of an AC socket, a DC socket, a USB socket and a charging interface.

The panel is connected to the protection circuit. Input and output ports are arranged on the panel. The input and output ports include an input port and an output port.

In one exemplary embodiment, the input and output ports are positioned on the AC socket, the DC socket, the USB socket and the charging interface. The ports of the AC socket, the DC socket and the USB socket are the output ports, and the port of the charging interface is the input port.

The arrangement for the panel, the panel circuit, the protection circuit, the input and output ports, the function panel, the electrical system, the power interface circuit and energy interface is as follows:
The panel circuit includes the protection circuit, and the input and output ports are arranged on the panel;
The function panel is arranged on the front surface of the compartment and includes a power interface circuit (the energy interface for supplying power to the vehicle is located on the power interface circuit), an energy switch and a data display screen (i.e., the display screen in Fig. 7), and the function panel is independent of the electrical system;
The arrangement for the bus device, the connector, the connection interface and the plug-in terminal is as follows:
   The bus device includes three connectors which are provided with plug-in terminals, and an interface formed on the plug-in terminal is a connection interface, and a connector can be arranged at one end of the cable (see Fig. 5).

MPPT is the maximum power point tracking device.

In Fig. 7, both the side wall assembly and the ceiling assembly are bonded-type flexible photovoltaic assembly devices. The three bonded-type flexible photovoltaic assembly devices are connected with the DC power supply through the three maximum power point tracking devices. The three reel-type flexible assemblies are three standard strings.

The above embodiments are only for providing detailed description of this application, and are not intended to limit the protection scope thereof which is defined by the claims.

## Claims

1. A reel-type packaged flexible assembly module (8), wherein the reel-type packaged flexible assembly module comprises a packaging cloth (9), cables and two or more flexible photovoltaic assemblies (10), wherein the two or more flexible photovoltaic assemblies (10) are bonded to the packaging cloth (9), and the cables are electrically connected with the flexible photovoltaic assemblies (10).

2. The reel-type packaged flexible assembly module of claim 1, wherein the two or more flexible photovoltaic assemblies (10) are bonded to one packaging cloth (9) and connected in series by the cables.

3. The reel-type packaged flexible assembly module of claim 1 or 2, wherein edges of the packaging cloth (9) are folded to enclose four edges of the flexible photovoltaic assembly, and the four edges of the flexible photovoltaic assembly (10) are enclosed by a sealant.

4. The reel-type packaged flexible assembly module of any one of claims 1 to 3, wherein the packaging cloth (9) is a wear-resistant interlining cloth.

5. The reel-type packaged flexible assembly module of any one of claims 1 to 4, wherein one or more of a hole (11), a hook-and-loop fastener (12) and a hard material are arranged at both ends of the packaging cloth (9).

6. The reel-type packaged flexible assembly module of claim 5, wherein a plurality of the holes (11) are provided and configured to connect with adjacent reel-type packaged flexible assembly modules, wherein the hook-and-loop fastener (12) is configured to bond two reel-type packaged flexible assembly modules together, wherein the hard material has a length which is equal to a width of the packaging cloth (9), and the hard material is elongated rod-shaped, arranged on both ends of the packaging cloth (9), and horizontally across the packaging cloth (9).

7. The reel-type packaged flexible assembly module of any one of claims 1 to 6, wherein the two or more flexible photovoltaic assemblies (10) are horizontally arranged on the packaging cloth (9), and wherein the cables comprise cables connected in series (15) between the flexible photovoltaic assemblies (10) horizontally arranged and bus cables (16) used for parallel connecting a plurality of the reel-type packaged flexible assembly module.

8. The reel-type packaged flexible assembly module of any one of claims 1 to 7, wherein a thin tubular storage hidden bag is provided on a surface of the packaging cloth (9) for holding the cables.

9. The reel-type packaged flexible assembly module of claim 8, wherein the thin tubular storage hidden bag has an H-shaped overall layout, wherein a middle horizontal portion of the thin tubular storage hidden bag is configured to hold the cables connected in series (15) between the flexible photovoltaic assemblies (10) horizontally arranged, and longitudinal portions on both sides of the thin tubular storage hidden bag are used to arrange the bus cables (16).

10. The reel-type packaged flexible assembly module of any one of claims 1 to 9, wherein two or four ends of the reel-type packaged flexible assembly module are provided with a T-shape bus device (17) which comprises a connector (13) configured to enable a parallel electrical connection between two described reel-type packaged flexible assembly modules or enable an electrical connection between the reel-type packaged flexible assembly module and an electrical appliance.

11. The reel-type packaged flexible assembly module of claim 10, wherein the T-shape bus device (17) comprises three connectors (13) and connection cables (19) connected between the three connectors (13), the three connectors (13) have three identical plug-in terminals, forming a three-way electrical connection.

12. A reel-type flexible photovoltaic power strip, comprising a plurality of the reel-type packaged flexible assembly modules of any one of claims 1-11, wherein the reel-type packaged flexible assembly modules are electrically connected in parallel.

13. The reel-type flexible photovoltaic power strip of claim 12 wherein the plurality of the reel-type packaged flexible assembly modules are connected in parallel by a group of bus cables (16) to form a standard string, and each group of bus cables (16) is configured to connect with a maximum power point tracking device.
